# EUROPEAN PATENT APPLICATION

(11) **EP 1 865 489 A2**
(43) Date of publication of application: **12.12.2007**
(21) Application number: 07011000.2
(22) Date of filing: 05.06.2007
(51) Int. Cl.: G09G 3/36

(54) **Liquid crystal display device and integrated circuit chip therefor**

(30) Priority: 08.06.2006 KR 20060051374
(71) Applicant: Samsung Electronics Co., Ltd., Yeongtong-gu Suwon-si, Gyeonggi-do (KR)
(72) Inventor: Hong, Sunkwang, Seongnam-si Gyeonggi-do (KR); Kim, Sang-Soo, Seoul (KR)
(74) Representative: Weitzel, Wolfgang

(57) **Abstract**

A display device includes a plurality of pixels; a gate driver that supplies a gate signal to the pixels; a data driver that supplies a data voltage to the pixels; an additional frame generator that generates an image signal of a third frame based on an image signal of a first frame and a second frame; a signal correction unit that corrects an image signal to generate the corrected image signal; and a signal controller that arranges the corrected Image signal to supply the arranged signal to the data driver and that controls the data driver and the gate driver, wherein the additional frame generator, the signal correction unit, and the signal controller are integrated in one IC chip.

## Description

### BACKGROUND OF THE INVENTION

### Field of the Invention

The present invention relates to a liquid crystal display and a driver IC chip therefor.

### Description of the Related Art

In an active type flat panel display, a plurality of pixels are arranged in a matrix shape and an image is displayed by controlling the luminance of each pixel depending on the supplied image information,

Among flat panel displays, the liquid crystal display includes two panels that include pixel electrodes and a common electrode. A liquid crystal layer that has dielectric anisotropy is interposed between the two panels. A desired image is obtained by controlling the transmittance of light passing through the liquid crystal layer by applying a varying electric field to the liquid crystal layer.

As the liquid crystal display is widely in television sets as well as computer monitors, it is necessary to be able to display motion pictures. However, it is difficult for the liquid crystal display to display a motion picture because the liquid crystal molecules have slow response speed. Furthermore, since the liquid crystal display is a hold-type display device, blurring of images may occur when a motion picture is displayed.

### SUMMARY OF THE INVENTION

According to one aspect of an exemplary embodiment of the present invention, a liquid crystal display includes: a plurality of pixels; a gate driver that supplies a gate signal to the pixels; a data driver that supplies a data voltage to the pixels; an additional frame generator that generates an image signal of a third frame based on an image signal of a first frame and a second frame; a signal correction unit that corrects an image signal to generate the corrected image signal; and a signal controller that arranges the corrected image signal to supply the arranged signal to the data driver and that controls the data driver and the gate driver. The additional frame generator, the signal correction unit, and the signal controller are integrated in one IC chip.

The first frame, the third frame, and the second frame may be sequentially continuously connected.

The additional frame generator may include a motion vector generator that generates a motion vector depending on an image signal of the first and second frames, and an additional signal generator that generates image signals of the third frame depending on the motion vector.

The motion vector generator may generate the motion vector based on a previous motion vector.

The additional frame generator may further include a motion vector storage that stores a motion vector from the motion vector generator, wherein the motion vector generator may receive a motion vector that is stored in the motion vector storage as the previous motion vector.

In each pixel, an image signal of the third frame may have a gray between an image signal of the first frame and an Image signal of the second frame.

The signal correction unit may correct an image signal corresponding to a target data voltage of the pixel to generate a corrected image signal corresponding to a data voltage having a value that is different from the target data voltage.

A corrected image signal for the image signal of the third frame may be obtained depending on the image signal of the first frame.

The data driver may output the data voltage with a frame frequency that is different from an input frame frequency of the first and second frame image signals.

The liquid crystal display may further include an image signal storage that stores the image signal of the first and second frames to provide the signal to the additional frame generator and the signal correction unit.

The liquid crystal display may further include a receiver that receives the image signal of the first and second frames from the outside to transfer the signal to the image signal storage, and that is provided within the IC chip.

The image signal may be transferred with an LVDS (low voltage differential signaling) scheme.

The signal correction unit may include a gamma correction unit that performs gamma correction of the image signal to generate the corrected image signal.

Each pixel may include a first subpixel and a second subpixel.

The gamma correction unit may perform gamma correction of each of the image signals of the first to third frames for the each pixel to generate a corrected image signal for the first subpixel and a corrected image signal for the second subpixel.

The corrected image signal for the first subpixel and the corrected image signal for the second subpixel may be obtained by converting the image signal depending on different gamma functions.

The signal correction unit may further include a signal processor that corrects the corrected image signal for the first and second subpixels based on a corrected image signal for the first and second subpixels of a previous frame, respectively.

The data driver may output the data voltage with a frame frequency that is different from an input frame frequency of the first and second frame image signals.

Another embodiment of the present invention provides a driver IC chip for a display device, including: a receiver that receives an input image signal from the outside; an additional frame generator that generates an additional image signal based on the input image signal from the receiver; a signal correction unit that corrects the image signal to generate a corrected image signal; and a signal controller that arranges the corrected image signal and that generates a control signal for controlling the display of the corrected image signal.

The input image signal may include image signals of the first frame and the second frame, and the additional images signal may include an image signal of the third frame; the additional frame generator may generate an Image signal of the third frame based on the image signals of the first frame and the second frame; and the first frame, the third frame, and the second frame may be sequentially continuously connected.

The additional frame generator may include a motion vector generator that generates a motion vector depending on the image signals of the first and second frames, and an additional signal generator that generates an image signal of the third frame depending on the motion vector.

The motion vector generator may generate the motion vector based on a previous motion vector.

The additional frame generator may further include a motion vector storage that stores the motion vector from the motion vector generator, and the motion vector generator may receive a motion vector that is stored in the motion vector storage as the previous motion vector.

In each pixel, the image signal of the third frame may have a gray between the image signal of the first frame and the image signal of the second frame.

The signal correction unit may correct an image signal corresponding to a target data voltage of the pixel to generate a corrected image signal corresponding to a data voltage having a value that is different from the target data voltage.

A corrected image signal for the image signal of the third frame may be obtained depending on the image signal of the first frame.

The control signal may allow the corrected image signal to display with a frame frequency that is different from an input frame frequency of the first and second frame image signals.

The driver IC chip may further include an image signal storage that stores the image signals of the first and second frames to provide the signal to the additional frame generator and the signal correction unit.

The image signal may be transferred with an LVDS scheme.

The signal correction unit may include a gamma correction unit that performs gamma correction of each of the image signals of the first to third frames for each pixel to generate the corrected image signal.

The signal correction unit may further include a signal processor that corrects each of the corrected image signals based on a corrected image signal of a previous frame.

The signal controller may generate the control signal that controls the display of the corrected image signal with a frame frequency that is different from an input frame frequency of the first and second frame image signals.

Yet another embodiment of the present invention provides a liquid crystal display including: a display panel that includes a plurality of pixels and that displays an image; a lighting unit that irradiates light to the display panel; an integrated control chip that generates an additional image signal based on an input image signal entering from the outside and that corrects the image signal to generate a corrected image signal, and that generates a control signal for controlling the display of the corrected image signal; a data driving circuit that converts the corrected image signal to a data voltage depending on the control signal to supply the data voltage to the display panel with a frame frequency that is higher than a frame frequency of the input image signal; and a module member that couples and fixes the display panel, the lighting unit, the integrated control chip, and the data driver circuit and that protects them from the outside.

The integrated control chip may include an additional frame generator that generates an additional image signal of a middle frame based on an Input image signal of two continuous frames; a signal correction unit that corrects the image signal to generate a corrected image signal: and a signal controller that arranges the corrected image signal and that generates a control signal for controlling the display of the corrected image signal.

In the signal correction unit, each of the image signals may be obtained by correcting based on an image signal of a previous frame.

The signal correction unit may convert each of the image signals to at least two different corrected image signals.

### BRIEF DESCRIPTION OF THE DRAWINGS

The present invention will be described more fully hereinafter with reference to the accompanying drawings, in which:

FIG. 1 is an exploded perspective view of a liquid crystal display according to an exemplary embodiment of the present invention,

FIG. 2 is a block diagram of a liquid crystal display according to an exemplary embodiment of the present invention.

FIG. 3 is an equivalent circuit diagram of one pixel in a liquid crystal display according to an exemplary embodiment of the present invention.

FIG. 4 is a block diagram of an integrated control unit in a liquid crystal display according to an exemplary embodiment of the present invention.

FIG. 5 is an equivalent circuit diagram of one pixel in a liquid crystal display according to another exemplary embodiment of the present invention.

FIG. 6 is a block diagram of an integrated control unit in a liquid crystal display according to another exemplary embodiment of the present invention.

### DETAILED DESCRIPTION OF THE EMBODIMENTS

T In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

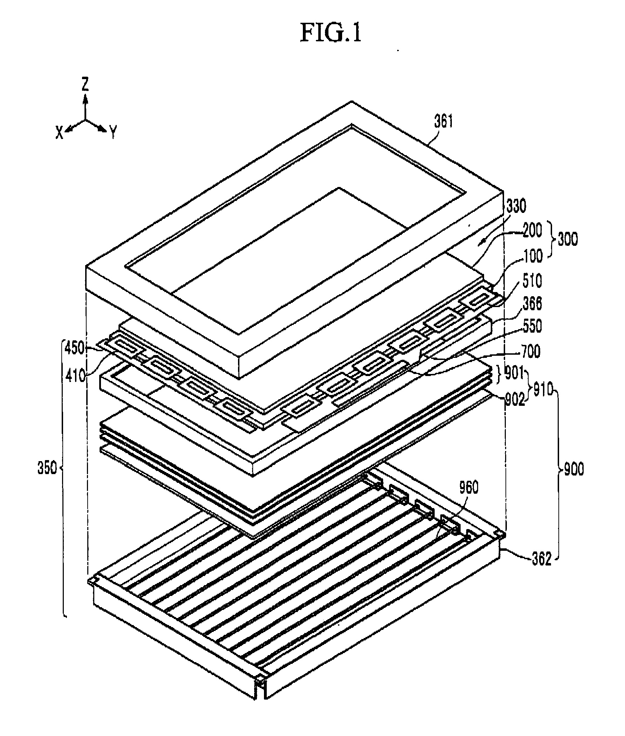

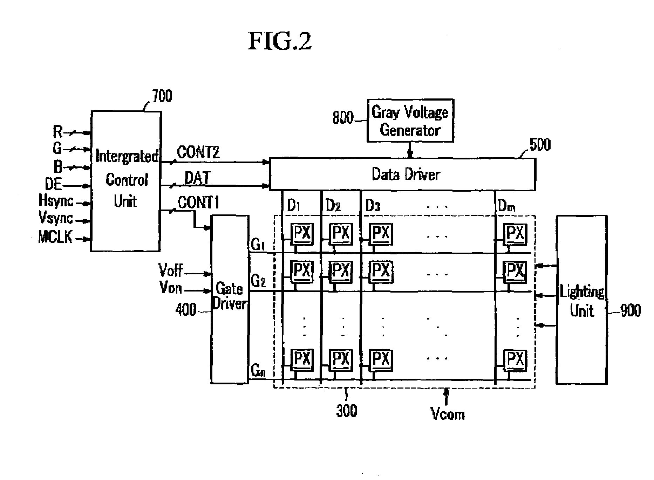

A liquid crystal display, which is an example of a display device, will be described in detail with reference to FIGS. 1 and 2.

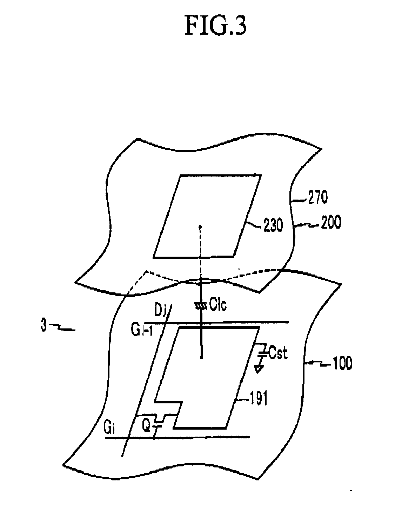

FIG. 1 is an exploded perspective view of a liquid crystal display according to an exemplary embodiment of the present invention, FIG. 2 is a block diagram of a liquid crystal display according to an exemplary embodiment of the present invention, and FIG. 3 is an equivalent circuit diagram of one pixel in a liquid crystal display according to an exemplary embodiment of the present Invention.

Referring to FIGS. 1 and 2, the liquid crystal display according to an exemplary embodiment of the present invention includes a liquid crystal module 350 including a display unit 330 and a lighting unit 900, upper and lower chassis 361 and 362 that receive the liquid crystal module 350, and a mold frame 366.

The display unit 330 includes a liquid crystal panel assembly 300, a plurality of gate TCPs (tape carrier packages) 410 and a data TCP 510 that are attached thereto, and a gate printed circuit board (PCB) 450 and a data PCB 550 that are attached to the corresponding TCPs 410 and 510.

The liquid crystal panel assembly 300 includes a plurality of signal lines G₁-Gₙ and D₁-Dₘ and a plurality of pixels PX that are connected thereto and arranged in approximately a matrix shape from an equivalent circuit view. The liquid crystal panel assembly 300 also Includes lower and upper panels 100 and 200 that are opposite to each other and a liquid crystal layer 3 that is interposed therebetween from a structural view as shown in FIG. 3.

The signal lines G₁-Gₙ and D₁-Dₘ include a plurality of gate lines G₁-Gₙ for transferring a gate signal (also referred to as a "scanning signal") and a plurality of data lines D₁-Dₘ for transferring a data voltage. The gate lines G₁-Gₙ are extended in approximately a row direction and almost parallel to each other, and the data lines D₁-Dₘ, are extended in approximately a column direction and almost parallel to each other.

Each pixel PX, for example a pixel PX that is connected to an i-th (i=1, 2, ..., n) gate line Gᵢ and a j-th (j=1, 2, ..., m) data line Dⱼ includes a switching element Q that Is connected to the signal lines Gᵢ and Dⱼ, and a liquid crystal capacitor Clc and a storage capacitor Cst that are connected thereto. The storage capacitor Cst may be omitted as needed.

The switching element Q is a three terminal element such as a thin film transistor that is provided in the lower panel 100, and a control terminal thereof is connected to the gate line Gᵢ, an input terminal thereof is connected to the data line Dⱼ, and an output terminal thereof is connected to the liquid crystal capacitor Clc and the storage capacitor Cst. The thin film transistor may include polysilicon or amorphous silicon.

The liquid crystal capacitor Clc has a pixel electrode 191 of the lower panel 100 and a common electrode 270 of the upper panel 200 as two terminals, and the liquid crystal layer 3 between the two electrodes 191 and 270 functions as a dielectric material. The pixel electrode 191 is connected to the switching element Q. and the common electrode 270 is formed on an entire surface of the upper panel 200 and receives a common voltage Vcom. Unlike the case of FIG. 3, the common electrode 270 may be provided in the lower panel 100, and If so, at least one of the two electrodes 191 and 270 may be formed in a line shape or a bar shape.

The storage capacitor Cst as an assistant of the liquid crystal capacitor Clc is formed with the overlap of a separate signal line (not shown) and the pixel electrode 191 that are provided in the lower panel 100 with an insulator interposed therebetween, and a predetermined voltage such as a common voltage Vcom is applied to the separate signal line. However, the storage capacitor Cst may be formed with the overlap of the pixel electrode 191 and a previous gate line directly over the electrode 191 via an insulator.

On the other hand, in order to represent color display, by allowing each pixel PX to inherently display one of the primary colors (spatial division) or to sequentially alternatively display the primary colors (temporal division), a desired color is recognized with the spatial and temporal sum of the primary colors. An example of a set of the primary colors includes red, green, and blue. FIG. 3 shows as an example of spatial division in which each pixel PX is provided with a color filter 230 for displaying one of the primary colors in a region of the upper panel 200 corresponding to the pixel electrode 191. Unlike the case of FIG. 3, the color filter 230 may be provided on or under the pixel electrode 191 of the lower panel 100.

At least one polarizer (not shown) for polarizing light is attached to the outside surface of the liquid crystal panel assembly 300.

Referring to again FIGS. 1 and 2, the gate TCP 410 is attached to one edge of the lower panel 100 of the liquid crystal panel assembly 300, and a gate driver IC constituting a gate driver 400 is mounted in a chip form thereon. A data TCP 510 is attached to another edge of the lower panel 100 of the liquid crystal panel assembly 300, and a data driver IC constituting a data driver 500 is mounted in a chip form thereon. The gate driver 400 and data driver 500 are respectively electrically connected to the gate lines G₁-Gₙ and the data lines D₁-Dₘ of the liquid crystal panel assembly 300 through a signal line (not shown) that is formed in the TCPs 410 and 510.

The gate driver 400 applies a gate signal consisting of a combination of a gate-on voltage Von and a gate-off voltage Voff to the gate line G₁-Gₙ, and the data driver 500 applies a data voltage to the data line D₁-Dₘ.

Alternatively, a driver IC chip constituting the gate driver 400 and the data driver 500 may be integrated and mounted in the display panel assembly 300, and at least one of the gate driver 400 and the data driver 500 along with the switching element Q and the signal lines G₁-Gₙ and Dₗ-Dₘ may be directly formed on the display panel assembly 300.

The gate PCB 450 is attached to the TCP 410 in a length direction in parallel to the lower panel 100, and a plurality of signal lines (not shown) that transfer a signal and electronic parts, etc., are formed thereon.

The data PCB 550 is attached to the TCP 510 in a length direction in parallel to the lower panel 100, and an integrated control unit 700, a gray voltage generator 800, electronic parts, and a plurality of signal lines (not shown) that transfers a signal, etc., are formed thereon.

integrated control unit 700 controls the gate driver 400 and the data driver 500, etc., and is represented with one integrated circuit (IC) chip. integrated control unit 700 and at least one of the gate driver 400 and the data driver 500 may be represented with one chip.

The gray voltage generator 800 generates two gray voltage sets related to transmittance of the pixel PX. One of the two sets has a positive value for a common voltage Vcom and the other set has a negative value.

As shown in FIGS. 1 and 2, the lighting unit 900 includes a plurality of lamps 960 and a plurality of optical devices 910.

The lamp 960 is fixed to a lower chassis 362 and is provided on the lower chassis 362. The lamp 960 includes, for example, a CCFL (cold cathode fluorescent lamp), an EEFL (external electrode fluorescent lamp), a light emitting diode (LED), etc., and may use a planar light source.

The optical device 910 is positioned between the assembly 300 and the lamp 960 and processes light from the lamp 960. The optical device 910 includes a diffuser 902 and a plurality of optical sheets 901 that are positioned between the assembly 300 and the lamp 960 and that guide and diffuse light from the lamp 960 to the LC panel assembly 300.

Although not shown in FIG. 1, an upper case and a lower case are positioned in an upper part of the upper chassis 361 and a lower part of the lower chassis 362, respectively, and a liquid crystal display is completed with the coupling thereof.

Theoperation of the liquid crystal display will now be described in detail.

Integrated control unit 700 receives input image signals R, G, and B and an input control signal that controls the display thereof from an external graphics controller (not shown). The input image signals R, G, and B include luminance information of each pixel PX, and the luminance has a predetermined number, for example 1024 (=2¹⁰), 256 (=2⁸), or 64 (=2⁶), of grays. The input control signal includes, for example, a vertical synchronization signal Vsync, a horizontal synchronization signal Hsync, a main clock signal MCLK, and a data enable signal DE.

Integrated control unit 700 generates an additional image signal based on the input image signals R, G, and, B and the input control signal, appropriately processes the input image signals R, G, and B and the additional image signal, and generates a gate control signal CONT1 and a data control signal CONT2. Thereafter, integrated control unit 700 sends the gate control signal CONT1 to the gate driver 400, and outputs the data control signal CONT2 and the processed image signal DAT to the data driver 500. The output image signal DAT is output in a frame frequency that is different from that of the input image signals R, G, and B, and this is called an FRC (frame rate control).

The gate control signal CONT1 includes a scanning start signal STV that instructs the scanning start and at least one clock signal that controls an output period of a gate-on voltage Von. The gate control signal CONT1 may further include an output enable signal OE that limits a sustain time of the gate-on voltage Von.

The data control signal CONT2 includes a horizontal synchronization start signal STH that starts the transfer of image data for one set of pixels PX, and a data clock signal HCLK and a load signal LOAD that apply a data signal to the liquid crystal panel assembly 300. The data control signal CONT2 may further include an inversion signal RVS for inverting the voltage polarity of a data signal to a common voltage Vcom (hereinafter, "voltage polarity of a data signal to a common voltage" is referred to as "polarity of a data signal").

The data driver 500 receives a digital image signal DAT of one set of pixels PX depending on the data control signal CONT2 from integrated control unit 700, converts the digital image signal DAT to an analog data signal by selecting a gray voltage corresponding to each digital image signal DAT, and then applies the converted signal to the corresponding data lines D₁-Dₘ.

The gate driver 400 applies a gate-on voltage Von to the gate lines G₁-Gₙ depending on the gate control signal CONT1 from integrated control unit 700 to turn on the switching element Q that is connected to the gate lines G₁-Gₙ. Then, a data signal that is applied to the data lines D₁-Dₘ is applied to a corresponding subpixel PX through the turned-on switching element Q.

The difference between voltages of the data signal that is applied to the pixel PX and common voltage Vcom is represented as a charge voltage, i.e., the pixel voltage of the liquid crystal capacitor Clc. Liquid crystal molecules change their arrangement depending on the magnitude of the pixel voltage so that the polarization of light passing through the liquid crystal layer 3 is changed. The change in the polarization results in a change in the transmittance of light at the polarizer that is attached to the display panel assembly 300, whereby the luminance is represented by the gray level of the image signal DAT.

By repeating the process for each unit of the horizontal period (referred to as "1 H", which is the same as one period of a horizontal synchronizing signal Hsync and a data enable signal DE), a gate-on voltage Von is sequentially applied to all gate lines G₁-Gₙ and a data signal is applied to all pixels PX, so that an image of one frame is displayed.

The state of the inversion signal RVS which is applied to the data driver 500 is controlled so that a next frame starts when one frame ends. The polarity of the data signal that is applied to each pixel PX is opposite to the polarity in the previous frame ("frame inversion"). In accordance with the characteristics of the inversion signal RVS within a frame, the polarity of a data signal flowing through a data line may be changed (e.g. row inversion and dot inversion) or the polarity of the data signals that are applied to one pixel row may be different from each other (e.g.: column inversion and dot inversion).

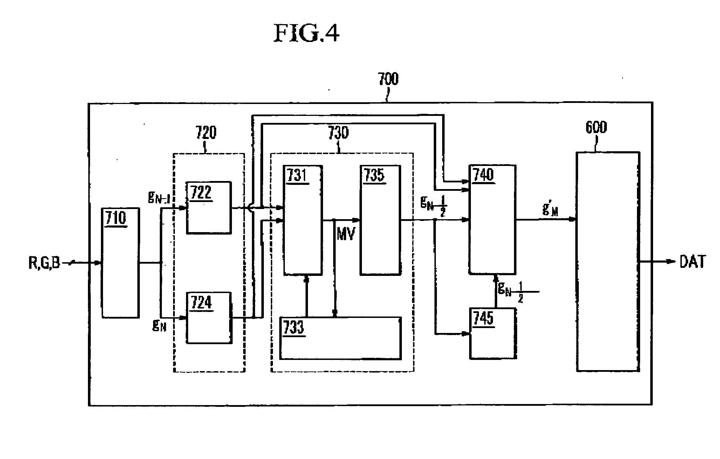

Hereinafter, an integrated control unit 700 according to an exemplary embodiment of the present invention will be described in detail with reference to FIG. 4.

FIG. 4 is a block diagram of an integrated control unit in a liquid crystal display according to an exemplary embodiment of the present invention.

Referring to FIG. 4, integrated control unit 700 includes a signal receiver 710, a storage 720, an additional frame generator 730, a DCC (dynamic capacitance compensation) processor 740, a DCC frame memory 745, and a signal controller 600. Integrated control unit 700 generates an image signal of a middle frame to enter between two frames based on the input image signal of two continuous frames, and generates a corrected image signal through processing such as DCC or ACC (accurate color capture).

First, signal receiver 710 receives the input image signals R, G, and B from an external device and rearranges and outputs them. The Input image signals R, G, and B can be transferred with a LVDS (low voltage differential signaling) scheme, and in this case the receiver 710 may include an LVDS display interface (LDI). Such an LDVS scheme is advantageous in view of noise, transmission speed, power consumption, etc.

The storage 720 includes first and second frame memories 722 and 724.

Each of the first and second frame memories 722 and 724 receives and stores an image signal of a frame from receiver 710, and the image signal of two continuous frames is alternately stored in the first frame memory 722 and the second frame memory 724. For better comprehension and ease of description, it is assumed that the first frame memory 722 stores an image signal g_{N-1} of an (N-1)-th (N = 1, 2, ..,) frame and the second frame memory 724 stores an Image signal g_{N} of an N-th frame.

The additional frame generator 730 generates an image signal of an additional frame for performing FRC (frame rate controlling), and includes a motion vector generator 731, a motion vector storage 733, and an additional signal generator 735. That is, the additional frame generator 730 generates an image signal gN-1/2 of an additional frame, i.e., a middle frame (referred to as a (N-1 /2)-th frame) to be positioned in-between two frames based on the input image signal g_{N-1}, (hereinafter, referred to as a "preceding image signal") of two continuous frames, for example an (N-1)-th frame (hereinafter, referred to as a "preceding frame'') and an input image signal g_{N} (hereinafter, referred to as a "following image signal") of an N-th frame (hereinafter, referred to as a "following frame").

The motion vector storage 733 stores a motion vector MV.

The motion vector generator 731 compares the preceding image signal 9_{N-1} of each pixel group (may include at least one adjacent pixel) (hereinafter, referred to as a "target pixel group") of the liquid crystal display with the following image signal g_{N} of its own or of another pixel group (hereinafter, referred to as a "comparative pixel group"). The motion vector generator 731 generates a motion vector MV for each pixel group based on the compared results, stores the vector in the motion vector storage 733, and outputs the vector to the additional signal generator 735. The motion vector MV is a vector that goes toward the matching pixel group from a target pixel group. The matching pixel group means a pixel group in which the following image signal g_{N} is the same as or most similar to the preceding image signal g_{N-1} of the target pixel group.

At this time, the motion vector generator 731 can determine a "comparative pixel group set" based on a previous motion vector MV that is stored in the motion vector storage 733. For example, the comparative pixel group set may be determined with a pixel group that is indicated by an end point of the previous motion vector and surrounding pixel groups thereof. The following image signal of a pixel group that is indicated by an end point of the previous motion vector MV is first compared with a preceding image signal of the target pixel group. If the result of the comparison shows that the two signals are not identical with each other, the comparative target may be widened to another pixel group within a comparative pixel group set.

At this time, the liquid crystal display divides the display area, which is a set of pixels, into several regions, and the pixels within each region may be included in the above-mentioned pixel group. The number of regions within a display area may sometimes be changed.

The additional signal generator 735 generates an image signal g_{N-1/2} of the middle frame ((N-1/2)-th frame) for inserting between the (N-1)-th frame and the N-th frame based on a motion vector MV that is received from the motion vector generator 731. The image signal g_{N-1/2} of the middle frame may be a middle value of an image signal g_{N-1} of the (N-1)-th frame and an image signal g_{N} of the N-th frame.

The DCC frame memory 745 stores the image signal g_{N-1/2} of the middle frame.

The DCC processor 740 generates a corrected image signal gM' (M=1/2. 1, 3/2, 2, ...) based on image signals gN-1 and gN-1/2 of the previous frame that is received from the storage 720 or the frame memory 745 and image signals gN-1 /2 and gN that is received from the additional signal generator 735 or the storage 720 of each pixel.

Hereinafter, the correction of the DCC processor 740 will be described in detail.

If a voltage is applied to both ends of the liquid crystal capacitor Clc, liquid crystal molecules of the liquid crystal layer 3 are rearranged in a stable state corresponding to the voltage. However, because the response speed of the liquid crystal molecules is slow, more or less time is required to arrive in a stable state. If a voltage that is applied to the liquid crystal capacitor Clc is continuously maintained, liquid crystal molecules continuously move until arriving at a stable state, and the light transmittance changes during this period. When the liquid crystal molecules no longer move as they arrive at the stable state, the light transmittance becomes constant.

Assuming that the pixel voltage in a stable state is the target pixel voltage and that the light transmittance at this time is the target light transmittance, the target pixel voltage and the target light transmittance correspond to each other. However, because a time of applying a data voltage by turning on a switching element Q of each pixel PX is limited, it is difficult for liquid crystal molecules to arrive in a stable state while applying a data voltage.

However, although the switching element Q is turned off, the voltage difference in both ends of the liquid crystal capacitor Clc still exists. Accordingly, the liquid crystal molecules continuously move toward a stable state.

In this way, if an arrangement state of the liquid crystal molecules changes, a dielectric constant of the liquid crystal layer 3 changes and thus the capacitance of the liquid crystal capacitor Clc changes. In a state where the switching element Q is turned off, one terminal of the liquid crystal capacitor Clc is in a floating state. Accordingly, if a leakage current is not considered, the total charges, which are stored in the liquid crystal capacitor Clc, are constant. Therefore, the change in capacitance of the liquid crystal capacitor Clc change causes the change in a voltage, i.e., a pixel voltage, in both ends of the liquid crystal capacitor Clc.

Therefore, if a data voltage (hereinafter, referred to as a "target data voltage") corresponding to a target pixel voltage based on a stable state is just applied to a pixel PX, an actual pixel voltage may be different from a target pixel voltage and thus target transmittance cannot be obtained.

Particularly, as the difference between target transmittance and initial transmittance of the pixel PX becomes large, the difference between the actual pixel voltage and the target pixel voltage becomes much larger.

Therefore, a data voltage that is applied to the pixel PX is required to be larger or smaller than a target data voltage, and one of the methods for performing this is DCC.

A corrected image signal g_{M}¹ of an M-th frame that is generated from the DCC processor 740 is represented with the following function F1:

g_{M}'=F1 (g_{M}, g_{M-1/2}) (Equation 1)Hereinafter, the image signal of a DCC processing target frame is referred to as the "current image signal" and the image signal of a just previous frame is referred to as the "previous image signal."

A corrected image signal g_{M}' is basically determined by experiments, and the difference between a corrected current Image signal g_{M}' and a previous image signal g_{M-1/2} is generally larger than the difference between a current image signal g_{M} before correction and a previous image signal g_{M-1/2}. However, when the current image signal g_{M} is equal to the previous image signal g_{M-1/2} or the difference between two is small, the corrected image signal g_{M}' may be equal to the current image signal g_{M} (i.e., may be not corrected).

Therefore, the data voltage that is applied to the pixel PX becomes higher or lower than the target data voltage.

Table 1 shows an example of the corrected image signal g_{M}' of the current image signal g_{M} for pairs of several previous image signals gM-1/2 and the current image signal gM when the number of grays is 256, and it may be stored in a lookup table.

**(Table 1)**

| | | g_{M-1/2} | | | | | | | | |
|---|---|---|---|---|---|---|---|---|---|---|
| | | 0 | 32 | 64 | 96 | 128 | 160 | 192 | 224 | 255 |
| g_{N} | 0 | 0 | 0 | 0 | 0 | 0 | 0 | 0 | 0 | 0 |
| | 32 | 115 | 32 | 22 | 20 | 15 | 15 | 15 | 15 | 15 |
| | 64 | 169 | 103 | 64 | 50 | 34 | 27 | 22 | 20 | 16 |
| | 96 | 192 | 146 | 118 | 96 | 87 | 70 | 54 | 36 | 29 |
| | 128 | 213 | 167 | 156 | 143 | 128 | 121 | 105 | 91 | 70 |
| | 160 | 230 | 197 | 184 | 179 | 174 | 160 | 157 | 147 | 129 |
| | 192 | 238 | 221 | 214 | 211 | 205 | 199 | 192 | 187 | 182 |
| | 224 | 250 | 245 | 241 | 240 | 238 | 238 | 224 | 224 | 222 |
| | 255 | 255 | 255 | 255 | 255 | 255 | 255 | 255 | 255 | 255 |

However, in order to store corrected image signals g_{M}' of all pairs, g_{M-1/2}, and g_{M} of the previous and current image signals, the size of the lookup table should be very large. Therefore, it is preferable that the corrected image signal g_{M}¹ be stored as the reference corrected image signal for only the previous and current image signal pairs 9_{M-1/2} and g_{M} of the same number as Table 1, for example. The corrected image signal g_{M}¹ is obtained by interplation based on the reference corrected image signal for the remaining previous and the current image signal pairs g_{M-1/2} and gM. Interpolation for a pair of random previous and current image signals g_{M-1/2} and g_{M} involves finding the reference corrected image signals for an image signal pair g_{M-1/2} and g_{M} of Table 1 that are close to the corresponding image signal pair g_{M-1/2} and g_{M}, and seeking a corrected image signal g_{M}' for a corresponding image signal pair g_{M-1/2} and g_{M} based on the signals.

For example, an image signal, which is a digital signal, is divided into a high bit and a low bit, and the reference corrected image signal for the previous image signal and the current image signal pair g_{M}-1/2 and g_{M} in which the low bit is 0 is stored In a lookup table. After related reference corrected image signals are found in the lookup table based on a high bit for the random previous and current image signal pair g_{M-1} and g_{M}, a corrected image signal g_{M}' is obtained using the reference corrected image signal that is found from the lookup table and the low bit of the previous and the current image signals g_{M-1/2} and g_{M}.

However, it may be difficult to obtain target transmittance even with this method. In this case, a voltage is again applied to the liquid crystal molecules in the present frame after the liquid crystal molecules have previously been inclined (hereinafter, referred to as a "pretllt") using a middle magnitude of voltage that was provided in the previous frame.

For this purpose, when an image signal g_{M} of a current frame is corrected, the DCC processor 740 considers the image signal of a next frame (hereinafter, referred to as a "next image signal") g_{M+1/2} as well as the image signal g_{M-1/2} of a previous frame. For example, when the current image signal g_{M} is to the same as the previous image signal g_{M-1/2} but the difference between the next image signal g_{M+1/2} and the current image signal g_{M} is large, the next frame is prepared by correcting the current image signal g_{M}.

In the highest gray or the lowest gray among the gray levels in which an image signal can be displayed, the image signal and the data voltage may be corrected or not. In order to correct the highest or lowest gray, a range of gray voltage, in which the gray voltage generator 800 generates a larger voltage than the target data voltage required for obtaining a target luminance range (or a target transmittance range), may be used.

Referring again to FIG. 4, signal controller 600 appropriately processes the corrected image signal gM¹ depending on an operating condition of liquid crystal panel assembly 300 based on the corrected image signal g_{M}' and a input control signal that is received from DCC processor 740, generates the gate control signal CONT1, the data control signal CONT2, and so on, and then sends the gate control signal CONT1 to the gate driver 400 and sends the data control signal CONT2 and the processed corrected-image signal as a digital image signal DAT to the data driver 500.

However, because a middle frame is generated between input frames, the number of output image signals DAT becomes twice that of the input image signals R, G₁ and B.

In order to transfer a large number of image signals, a wise bus transmission system can be used. In the wise bus transmission system, each of a plurality of data driver ICs (not shown) that are included in the data driver 500 receives only the image signal DAT that is required for itself, and the remaining image signals DAT are transferred to the next data driver IC through a data transmission line (not shown).

When an image signal DAT is transferred with this method, data transmission lines decrease one by one whenever they are passed through the data driver IC from the signal controller 600. Therefore, as the wiring number is reduced, logic for receiving-sending can be simultaneously reduced because of the reduced wiring number and thus power consumption of the data driver 500 can be reduced.

Data driver 500 applies a data voltage to the liquid crystal panel assembly 300 with a frequency that is twice that of the frame frequency (hereinafter, referred to as an "input frame frequency") of the input image signals R, G, and B. Therefore, blurring of the liquid crystal display can be effectively reduced.

As described above, integrated control unit 700 performs a complex operation such as FRC, DCC, and other signal processing, and is represented with one IC, Particularly, in the present exemplary embodiment, since a frame memory that is required when a middle image signal for the FRC is generated and a frame memory that is required when the DCC is processed are shared, the size of a memory can be reduced, compared to a case where a middle image signal is produced in a separate device. Furthermore, a structure of the receiver 710 can be simplified, compared to a case where a middle image signal is produced in a separate device (chip) and another device (chip) receives and processes the signal again.

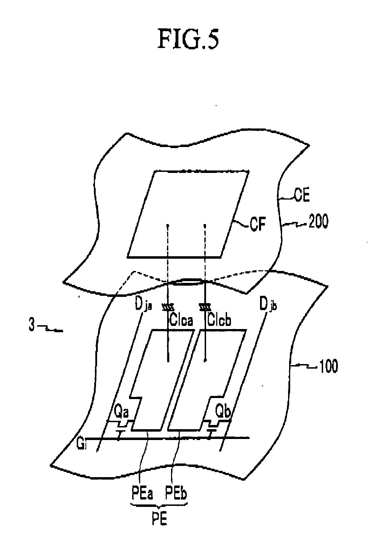

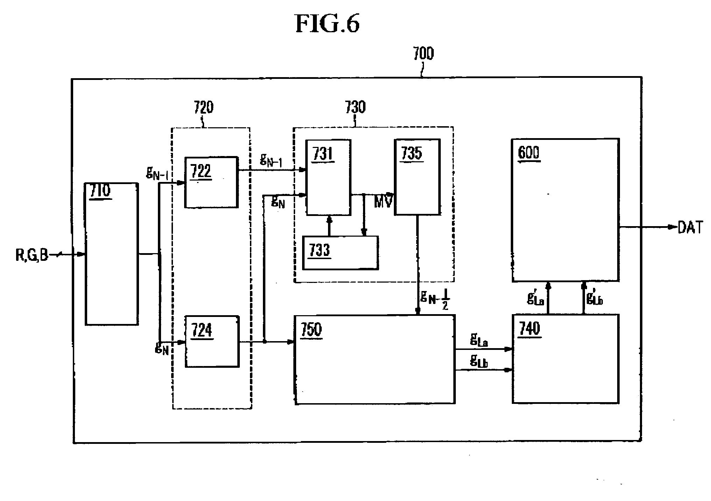

Referring to FIGS. 5 and 6, a liquid crystal display according to another exemplary embodiment of the present invention will be described in detail.

FIG. 5 is an equivalent circuit diagram of one pixel in a liquid crystal display according to another exemplary embodiment of the present invention, and FIG. 6 is a block diagram of an integrated control unit in a liquid crystal display according to another exemplary embodiment of the present invention.

Referring to FIG. 5, the liquid crystal panel assembly of the liquid crystal display according to the present embodiment includes a plurality of pixels PX, a plurality of gate lines Gi, and a plurality of pairs of data lines Dja and Djb.

As shown in FIG. 2, the pixels PX are arranged in a matrix shape. Each pixel PX includes a pair of subpixels PXa and PXb, and each of the subpixels PXa or PXb includes switching elements Qa or Qb that are connected to a corresponding gate line Gi and data lines Dja or Djb and liquid crystal capacitors Clca or Clcb that are connected to thereto. Each of the subpixels PXa and PXb may further include a storage capacitor (not shown) that is connected to the switching elements Qa and Qb.

The liquid crystal capacitors Clca and Clcb have subpixel electrodes PEa and PEb of the thin film transistor array panel 100 and a common electrode CE of the common electrode panel 200 as two terminals, and the liquid crystal layer 3 between the two electrodes PEa and PEb and CE functions as a dielectric material. The liquid crystal layer 3 may include a liquid crystal material having negative dielectric anisotropy, and the liquid crystal molecules of the liquid crystal layer 3 may be initially aligned to be perpendicular to a surface of the display panels 100 and 200.

The number of data lines Dja and Djb is two times that of the pixel array.

Referring to FIG. 6, integrated control unit 700 of the liquid crystal display having the pixel of FIG. 5 has a similar structure to that of integrated control unit 700 shown in FIG. 4.

That is, integrated control unit 700 shown in FIG. 6 includes a signal receiver 710, a storage 720, an additional frame generator 730, a DCC processor 740, and a signal controller 600. The storage 720 includes first and second frame memories 722 and 724, and the additional frame generator 730 includes a motion vector generator 731, a motion vector storage 733, and an additional signal generator 735.

However, integrated control unit 700 shown in FIG. 6 further includes a gamma correction unit 750 that generates an image signal to supply to each of the subpixels PXa and PXb.

The gamma correction unit 750 converts each image signal g_{N-1/2} and g_{N} for each pixel PX from the storage 720 and the additional signal generator 735 to one pair of first corrected image signals g_{La} and g_{Lb} (L = 1, 3/2, 2, ...) for two subpixels PXa and PXb. The one generated pair of first corrected image-signals g_{La} and g_{Lb} are image signals (may be described as g_{L}) that are converted depending on a different function. The gamma correction unit 750 may include a lookup table that stores a value of the first corrected image signals g_{La} and g_{Lb} for the input image signal _{9L}, and this lookup table may store independent data for each of the subpixels PXa and PXb.

The first corrected image signals g_{La} and g_{Lb} that are different from each other provide different voltages to both ends of the liquid crystal capacitors Clca and Clcb of the two subpixels PXa and PXb.

However, if the potential difference is generated in both ends of each of the liquid crystal capacitors Clca and Clcb, a primary electric field that is almost perpendicular to a surface of the display panels 100 and 200 is generated in the liquid crystal layer 3. Hereinafter, both of a pixel electrode PE and a common electrode CE are referred to as a "field generating electrode." Then, liquid crystal molecules of the liquid crystal layer 3 are inclined so that a long axis thereof is perpendicular to a direction of an electric field in response to an electric field, and the change degree of polarization of incident light to the liquid crystal layer 3 changes depending on an inclination degree of the liquid crystal molecules.

The inclination angle of the liquid crystal molecules changes depending on the intensity of the electric field. Since the voltages of the two liquid crystal capacitors Clca and Clcb are different from each other, the inclination angle of the liquid crystal molecules changes, whereby the luminance of the two subpixels PXa and PXb is changed. Therefore, if the voltages of the two liquid crystal capacitors Clca and Clcb are appropriately adjusted, an image seen from the side may be most similar to that seen from the front.That is, the side gamma curve may be most similar to the front gamma curve, thereby improving side visibility. Furthermore, by allowing an area of one of the subpixels PXa and PXb that receives a relatively high data voltage to be smaller than that of the other the subpixels PXa and PXb, the side gamma curve may be more similar to the front gamma curve.

By performing DCC processing in the first corrected image signals g_{La} and g_{Lb} from the gamma correction unit 750, the DCC processor 740 generates second corrected image signals g_{La}' and g_{Lb}'.

Therefore, the DCC processor 740 may include a lookup table that stores the second corrected image signals g_{La'} and g_{Lb}' corresponding to the first corrected image signals g_{La} and g_{Lb}, and the lookup table may be individually provided in each of subpixels PXa and PXb.

In order to perform the DCC, a frame memory for storing the first corrected image signals g_{La} and g_{Lb} that are supplied from the gamma correction unit 750 is required, and the frame memory may be provided within the DCC processor 740 or within integrated control unit 700 rather than the DCC processor 740.

The signal controller 600 receives the second corrected image signals g_{La}' and g_{Lb}' from the DCC processor 740, aligns the signals depending on a frame order, and transfers the signals as an output image signal DAT to the data driver 500.

In the present exemplary embodiment, since the total number of output image signals DAT is four times that of the input image signals R, G, and B, an output frame frequency of integrated control unit 700 may be four times that of an input frame frequency. However, since the number of data lines Dja and Djb of the display panel assembly 300 is two times that of the pixel rows, a scanning frame frequency of the display panel assembly 300 is two times that of an input frame frequency.

As described above, according to the present invention, since an integrated control unit that performs a complex operation such as FRC and DCC is represented with one IC, an interface between an external device and a liquid crystal display can be simplified and a memory can be reduced.

While this invention has been described In connection with what is presently considered to be practical exemplary embodiments, it is to be understood that the invention is not limited to the disclosed embodiments, but, on the contrary, is intended to cover various modifications and equivalent arrangements Included within the spirit and scope of the appended claims.

## Claims

1. A liquid crystal display comprising:
a plurality of pixels;
a gate driver that supplies a gate signal to the pixel;
a data driver that supplies a data voltage to the pixel;
an additional frame generator that generates an image signal of a third frame based on an image signal of a first frame and a second frame;
a signal correction unit that corrects the image signal to generate a corrected image signal; and
a signal controller that arranges the corrected image signal to supply the arranged signal to the data driver and that controls the data driver and the gate driver,
wherein the additional frame generator, the signal correction unit, and the signal controller are integrated in one IC chip.

2. The liquid crystal display of claim 1, wherein the first frame, the third frame, and the second frame are sequentially continuously connected in order.

3. The liquid crystal display of claim 2, wherein the additional frame generator comprises a motion vector generator that generates a motion vector depending on image signals of the first and second frames; and an additional signal generator that generates an image signal of the third frame depending on the motion vector.

4. The liquid crystal display of claim 3, wherein the motion vector generator generates the motion vector based on a previous motion vector.

5. The liquid crystal display of claim 4, wherein the additional frame generator further comprises a motion vector storage that stores a motion vector from the motion vector generator,
wherein the motion vector generator receives a motion vector that is stored in the motion vector storage as the previous motion vector.

6. The liquid crystal display of claim 5, wherein in each pixel, the image signal of the third frame has a gray between the image signal of the first frame and the image signal of the second frame.

7. The liquid crystal display of any one of claims 1 to 6, wherein the signal correction unit corrects an image signal corresponding to a target data voltage of the pixel to generate a corrected image signal corresponding to a data voltage having a value different from the target data voltage.

8. The liquid crystal display of claim 7, wherein a corrected image signal for the image signal of the third frame is obtained depending on the image signal of the first frame.

9. The liquid crystal display of claim 8, wherein the data driver outputs the data voltage with a frame frequency that is different from the input frame frequency of the first and second frame image signals.

10. The liquid crystal display of claim 9, further comprising an Image signal storage that stores the image signal of the first and second frames to provide the signal to the additional frame generator and the signal correction unit.

11. The liquid crystal display of claim 10, further comprising a receiver that receives the image signal of the first and second frames from the outside to transfer the signal to the image signal storage, and that is provided within the IC chip.

12. The liquid crystal display of claim 11, wherein the image signal is transferred with an LVDS (low voltage differential signaling) scheme.

13. The liquid crystal display of any one of claims 1 to 6, wherein the signal correction unit comprises a gamma correction unit that performs gamma correction of the image signal to generate the corrected Image signal.

14. The liquid crystal display of claim 13, wherein each pixel comprises a first subpixel and a second subpixel,

15. The liquid crystal display of claim 14, wherein the gamma correction unit performs gamma correction of each of the image signals of the first to third frames for each pixel to generate a corrected image signal for the first subpixel and a corrected image signal for the second subpixel.

16. The liquid crystal display of claim 15, wherein the corrected image signal for the first subpixel and the corrected image signal for the second subpixel are obtained by converting the image signal depending on different gamma functions.

17. The liquid crystal display of claim 16, wherein the signal correction unit further comprises a signal processor that corrects the corrected image signal for the first and second subpixels based on a corrected image signal for the first and second subpixels of a previous frame, respectively.

18. The liquid crystal display of claim 17, wherein the data driver outputs the data voltage with a frame frequency that is different from an input frame frequency of the first and second frame image signals.

19. A driver IC chip for a display device comprising :
a receiver that receives an input image signal from the outside;
an additional frame generator that generates an additional image signal based on the Input Image signal from the receiver;
a signal correction unit that corrects the image signal to generate a corrected image signal; and
a signal controller that arranges the corrected image signal and that generates a control signal for controlling the display of the corrected image signal.

20. The driver IC chip of claim 19, wherein the input image signal comprises image signals of the first frame and the second frame, and the additional images signal includes an image signal of the third frame;
the additional frame generator generates an image signal of the third frame based on the image signals of the first frame and the second frame; and
the first frame, the third frame, and the second frame are sequentially continuously connected.

21. The driver IC chip of claim 20, wherein the additional frame generator comprises:
a motion vector generator that generates a motion vector depending on the image signals of the first and second frames; and
an additional signal generator that generates an image signal of the third frame depending on the motion vector.

22. The driver IC chip of claim 21, wherein the motion vector generator generates the motion vector based on a previous motion vector.

23. The driver IC chip of claim 22, wherein the additional frame generator further comprises a motion vector storage that stores the motion vector from the motion vector generator; and
the motion vector generator receives a motion vector that is stored in the motion vector storage as the previous motion vector.

24. The driver IC chip of claim 23, wherein in each pixel, the image signal of the third frame has a gray between the image signal of the first frame and the image signal of the second frame.

25. The driver IC chip of any one of claims 19 to 24, wherein the signal correction unit corrects an image signal corresponding to a target data voltage of the pixel to generate a corrected image signal corresponding to a data voltage having a value that is different from the target data voltage.

26. The driver IC chip of claim 25, wherein a corrected image signal for the image signal of the third frame is obtained depending on the image signal of the first frame.

27. The driver IC chip of claim 26, wherein the control signal allows the corrected image signal to display with a frame frequency that is different from an input frame frequency of the first and second frame image signals.

28. The driver IC chip of claim 27, further comprising an image signal storage that stores the image signals of the first and second frames to provide the signal to the additional frame generator and the signal correction unit.

29. The driver IC chip of claim 28, wherein the image signal is transferred with an LVDS scheme.

30. The driver IC chip of any one of claims 19 to 24, wherein the signal correction unit comprises a gamma correction unit that performs gamma correction of each of the image signals of the first to third frames for each pixel to generate the corrected image signal.

31. The driver IC chip of claim 30, wherein the signal correction unit further comprises a signal processor that corrects each of the corrected image signals based on a corrected image signal of a previous frame.

32. The driver IC chip of claim 31, wherein the signal controller generates the control signal that controls the display of the corrected image signal with a frame frequency that is different from an input frame frequency of the first and second frame image signals.

33. A liquid crystal display comprising:
a display panel that comprises a plurality of pixels and that displays an image;
a lighting unit that irradiates light to the display panel;
an integrated control chip that generates an additional image signal based on an input image signal entering from the outside and that corrects the image signal to generate a corrected image signal, and that generates a control signal for controlling the display of the corrected image signal;
a data driving circuit that converts the corrected image signal to a data voltage depending on the control signal to supply the data voltage to the display panel with a frame frequency that is higher than a frame frequency of the input image signal; and
a module member that couples and fixes the display panel, the lighting unit, the integrated control chip, and the data driver circuit, and that protects them from the outside.

34. The liquid crystal display of claim 33, wherein the integrated control chip comprises:
an additional frame generator that generates an additional image signal of a middle frame based on an input Image signal of two continuous frames;
a signal correction unit that corrects an image signal to generate a corrected image signal; and
a signal controller that arranges the corrected image signal and that generates a control signal for controlling the display of the corrected image signal.

35. The liquid crystal display of claim 34, wherein in the signal correction unit, each of the image signals is obtained by correcting based on an image signal of a previous frame.

36. The liquid crystal display of claim 34, wherein the signal correction unit converts each of the image signals to at least two different corrected image signals.
